# EUROPÄISCHE PATENTSCHRIFT

(11) **EP 0 470 095 B1**
(45) Veröffentlichungstag und Bekanntmachung des Hinweises auf die Patenterteilung: **16.03.1994**
(21) Anmeldenummer: 90906129.3
(22) Anmeldetag: 25.04.1990
(51) Int. Cl.: G01R 33/40, G01R 33/42, H01F 7/22

(54) **MAGNETSYSTEM MIT SUPRALEITENDEN FELDSPULEN**
MAGNET SYSTEM WITH SUPERCONDUCTING FIELD COILS
SYSTEME MAGNETIQUE A BOBINES INDUCTRICES SUPRACONDUCTRICES

(30) Priorität: 29.04.1989 DE 3914243
(43) Veröffentlichungstag der Anmeldung: 12.02.1992
(73) Patentinhaber: BRUKER Analytische Messtechnik GmbH, 76287 Rheinstetten (DE)
(72) Erfinder: KASTEN, Arne, D-7500 Karlsruhe 1 (DE); MÜLLER, Wolfgang, Hans-Georg, D-7500 Karlsruhe (DE)
(74) Vertreter: KOHLER SCHMID + PARTNER
(86) Internationale Anmeldenummer: DE9000300
(87) Internationale Veröffentlichungsnummer: WO9013824

(56) Entgegenhaltungen:
- EP-A- 0 144 171
- EP-A- 0 167 243
- DE-A- 3 829 175
- GB-A- 2 205 444
- GB-A- 2 206 242
- US-A- 4 724 412
- Review of Scientific Instruments, Volume 56, No. 3, March 1985, American Institute of physics, (New York, US), A. R. Rath et al.: "Opposed coil magnet calculations for large sample and unilateral nuclear-magnetic-resonance", pages 402-410
- IEEE Transactions on Magnetics, Volume MAG-23, No. 2, March 1987, IEEE, (New York, US), M. A. Green et al.: "A 4.7 tesla magnet for magnetic resonance imaging and spectroscopy", pages 1299-1302

## Beschreibung

Die Erfindung betrifft ein Magnetsystem mit supraleitenden Feldspulen zur Erzeugung eines für NMR-Untersuchungen geeigneten konstanten Magnetfeldes, das im Untersuchungsvolumen eine hohe Feldstärke und eine für NMR-tomographische und/oder -spektroskopische Untersuchungen hinreichende Homogenität hat, und mit den weiteren, im Oberbegriff des Patenanspruch 1 genannten, gattungsbestimmenden Merkmalen.

Derartige Magnetsysteme, die zwei koaxial bezüglich der durch die Feldrichtung im Homogenitätsbereich ausgezeichneten Längsachse angeordnete Spulensysteme unterschiedlichen mittleren Durchmessers haben, welche rotationssymmetrisch ausgebildet und symmetrisch zu der zur Längsachse normalen Quermittelebene des Systems angeordnet sind und mit Strömen erregbar sind, aus denen Magnetfelder resultieren, die im Außenraum des Magnetsystems eine weitgehende Kompensation der Dipolfelder beider Spulensysteme, zumindest annähernd, Vermitteln, sind bekannt (z. B. durch EP 0 138 270 A2, EP 0 144 171 A1, DE 38 29 175 A1 sowie GB 2 206 242 A).

Bei dem durch die EP 0 144 171 A1 bekannten Magnetsystem sind die Feldspulen, deren (Dipol- )Felder im Außenraum des Magnetsystems weitgehend kompensiert werden sollen, im Sinne einer Festverdrahtung in Reihe geschaltet. Bei dem durch die DE 38 29 175 A1 bekannten Magnetsystem ist als Alternative zu einer Reihenschaltung der die beiden entgegengesetzt gerichteten magnetischen Momente entwickelnden Felspulen auch deren Parallelschaltung offenbart. Zwar können diese bekannten Systeme mit Strömen unterschiedlicher Stärke betrieben werden, ohne daß hierunter die Abschirmwirkung im Außenraum nennenswert beeinträchtigt wird, jedoch sind die ausnutzbaren Feldstärken dadurch, daß das von der äußeren Feldspule erzeugte Magnetfeld stets demjenigen von der inneren Feldspule erzeugten Magnetfeld entgegengesetzt gerichtet ist, auf einen Betrag beschränkt, der kleiner ist als die absolute Feldstärke des von der inneren Feldspule erzeugten Magnetfeldes.

Im Unterschied dazu sind durch die EP 0 138 270 A2 und die GB 2 206 242 A bekannte Magnetsysteme der eingangs genannten Art dahingehend ausgebildet, daß die beiden supraleitenden Feldspulen mit Strömen unterschiedlicher Stromstärke geladen werden können, wobei die Ladung mindestens einer der beiden Feldspulen induktiv erfolgt und die beiden Feldspulen je für sich einen eigenen geschlossenen Stromkreis bilden. Je nach dem, bis zu welchem Betrag der Stromstärke die abschirmende - äußere - Feldspule geladen wird, ist es dann möglich, die im Untersuchungsfall ausnutzbare Feldstärke zwischen einem Minimal-Wert, der sich ergibt, wenn die äußere, abschirmende Feldspule - bei vorgegebener Ladung der inneren Feldspule - bis zu einem maximalen Betrag ihrer Betriebsstromstärke aufgeladen wird und einem Maximalwert zu variieren, der sich ergibt, wenn die äußere, abschirmende Feldspule nicht geladen wird.

Die mit den bekannten, durch eine äußere Feldspule im Außenraum aktiv abschirmbaren Magnetsystemen im Untersuchungsraum ausnutzbaren Magnetfeldstärken sind daher für zahlreiche Untersuchungszwecke zu gering, so daß die bekannten Magnetsysteme allenfalls für tomographische Untersuchungen geeignet erscheinen, bei denen es in erster Linie auf gute Feldhomogenität in einem möglichst großen Untersuchungsvolumen ankommt, eine hohe Feldstärke aber nicht von entscheidender Bedeutung ist. Für Untersuchungszwecke hingegen, z. B. NMR-spektroskopische Experimente, bei denen es weniger auf eine gute Homogenität des Magnetfeldes in einem möglichst großen Untersuchungsvolumen bei mäßiger Feldstärke, dafür aber - bei gleichwohl guter Homogenität des Feldes in einem relativ kleinen Untersuchunsvolumen - auf eine möglichst hohe Feldstärke ankommt, sind die bekannten Magnetsysteme daher nicht geeignet.

Aufgabe der Erfindung ist es daher, ein Magnetsystem der eingangs genannten Art dahingehend zu verbessern, daß es bei gleichwohl einfachem Aufbau sowohl für NMR-tomographische als auch für spektroskopische Zwecke, das heißt z. B. wissenschaftlich-analytische Untersuchungen, gleichermaßen geeignet ist.

Diese Aufgabe wird erfindungsgemäß dadurch gelöst, daß eine Betriebsart-Wahlschaltereinrichtung vorgesehen ist, mittels der das Magnetsystem alternativ zu der die - weitgehende - Dipolfeld-Kompensation im Außenraum des Magnetsystems vermittelnden Betriebsart auch auf mindestens diejenige Betriebsart umstellbar ist, in welcher die von den beiden Spulensystemen im Zentrum derselben erzeugten magnetischen Felder gleichgerichtet sind.

Das erfindungsgemäße Magnetsystem hat, vom Benutzer aus gesehen, den Vorteil, daß es die Option auf zwei unterschiedliche Nutzungsmöglichkeiten bietet, den Abschirmungsbetrieb bei relativ niedriger Feldstärke, jedoch mit einem großen Homogenitätsvolumen, einerseits, und andererseits den Hochfeldbetrieb, der bei gleichwohl guter Homogenität in einem zwar relativ kleineren Untersuchungsvolumen die Ausnutzung wesentlich höherer Magnetfeldstärken erlaubt; insofern erscheint das erfindungsgemäße Magnetsystem zunächst für Forschungszwecke als besonders geeignet, wo in aller Regel eine größere Variationsbreite der experimentellen Randbedingungen gefordert wird als im diagnostisch-medizinischen Bereich - z. B. Ganzkörper-Tomographie - für die das erfindungsgemäße Magnetsystem - eingestellt auf den Abschirmungsbetrieb - gleichermaßen gut geeignet ist.

Herstellerseitig ist als beachtlicher Vorteil anzusehen, daß ein und dasselbe Magnetsystem für entsprechend unterschiedliche Nutzungszwecke angeboten werden kann, wodurch sowohl eine erhebliche Rationalisierung der Herstellung als auch eine Verbesserung der Lieferfähigkeit bei gleichwohl reduziertem Mindest-Lagerbestand erzielt werden kann.

Wenn das Verhältnis des Betrages der Feldstärke des von der inneren Feldspule des Magnetsystems erzeugten Magnetfeldes zum Betrag der Feldstärke des von der äußeren Feldspule des Magnetsystems erzeugten Feldes einen Wert um 3/1 hat, so kann im Hochfeldbetrieb des Magnetsystems ein Magnetfeld erzielt werden, das dem Betrage nach doppelt so hoch wie im Abschirmungsbetrieb des Magnetsystems ist.

In der durch die Merkmale des Anspruchs 3 angegebenen Auslegung der beiden Feldspulen des Magnetsystems erzeugen diese, je für sich gesehen, Felder guter Homogenität, aus deren Überlagerung, unabhängig davon, ob die beiden Feldspulen von Strömen gleicher oder verschiedener Stromstärke durchflossen werden, wieder ein Magnetfeld resultiert, dessen Homogenität mindestens dem "geringeren" Wert der Homogenitäten der beiden Feldspulen entspricht.

Durch die Merkmale der Ansprüche 4 und 5 sind spezielle, bevorzugte Gestaltungen der äußeren und der inneren Feldspule des erfindungsgemäßen Magnetsystems angegeben, die der Auslegung gemäß Anspruch 3 entsprechen.

In Kombination hiermit ist durch die Merkmale des Anspruchs 6 eine Auslegung des Magnetsystems angegeben, die hinsichtlich der im Abschirmungsbetrieb und im Hochfeldbetrien erzielbaren Feldstärken der Auslegung gemäß Anspruch 2 entspricht.

In Verbindung hiermit ist durch die Merkmale des Anspruchs 7 ein spezielles Ausführungsbeispiel spezifiziert, das für eine Anwendung in einem Ganzkörper-Tomographen geeignet ist und im Abschirmungsbetrieb im Zentrum eine Feldstärke von 1 T, im Hochfeldbetrieb eine solche von 2 T erzeugt.

Die gemäß Anspruch 8 vorgesehene Serienschaltung der beiden Feldspulen des Magnetsystems ist aus Gründen der Quench-Sicherheit des supraleitenden Magnetsystems vorteilhaft.

Die Betriebsmodus-Wahlschalteinrichtung, mittels derer vor dem Aufbau des Suprastromes - dem Laden - das Magnetsystem auf die jeweils erwünschte Betriebsart - Abschirmungsbetrieb oder Hochfeldbetrieb - einstellbar ist, kann als einfacher, mechanischer, mehrpoliger Schalter realisiert sein, in welchem Falle jedoch ein permanenter Anschluß des Spulensystems an das elektrische Ladegerät erforderlich ist.

Dieser Nachteil ist auf einfache Weise durch ein gemäß Anspruch 9 vorgesehenes supraleitendes Netzwerk als Betriebsmodus-Wahlschalteinrichtung vermeidbar, das gemäß den Ansprüchen 10 und 11 auf einfache Weise realisierbar ist. Durch ein solches Netzwerk wird auch erreicht, daß bei einem z.B. durch einen Windungsbruch bedingten Ausfall einer der beiden Feldspulen des Magnetsystems die andere Feldspule wieder geladen und für sich zur Erzeugung eines Magnetfeldes mit eingeschränktem Homogentitätsbereich benutzt werden kann.

Da in den beiden möglichen Betriebsarten des erfindungsgemäßen Magnetsystems auf dessen Wicklungen unterschiedliche Kräfte wirken, die auch zu entsprechend verschiedenen, und seien es auch nur geringfügigen, Deformationen der die Feldspulen und deren Wicklungen tragenden Spulenkörper führen, wodurch auch die Feldhomogenität unterschiedlich beeinflußt wird, ist es vorteilhaft, wenn das Magnetsystem auch mit einem gut ausgestatteten Shim-System versehen ist, mit dem aus geringfügigen Verrückungen der Teilwicklungen der Feldspulen resultierende Feld-Inhomogenitäten wieder kompensiert werden können.

Durch die Merkmale der Ansprüche 13 bis 19 sind alternativ oder in Kombination anwendbare Realisierungsmöglichkeiten eines diesbezüglich geeigneten Shim-Systems angegeben.

Um auch für den Hochfeldbetrieb eine Mindestabschirmung des Magnetsystems nach außen hin zu erzielen, sowie z. B. für den Fall, daß nur eine der beiden Feldspulen für den Betrieb ausgenutzt wird bzw. zur Verfügung steht, kann - zusätzlich - auch noch eine Eisenabschirmung vorgesehen sein. Für jede der beiden Betriebsarten kann der Einfluß einer solchen Eisenabschirmung auf die Feldstärke und die Homogenität bei der Berechnung des Magnetsystems (vgl. H. Brechna, "Super Conducting Magnet Systems, Technische Physik in Einzeldarstellungen, Band 18, Springer-Verlag Berlin, Heidelberg, New York, L.F. Bergmann Verlag, München, 1973) berücksichtigt werden.

Sowohl aus Gründen der Raumersparnis als auch aus konstruktiven Gründen ist es besonders vorteilhaft, wenn eine solche Eisenabschirmung, die in für sich bekannter Weise aus Stirnplatten und diese miteinander verbindenden, balkenförmigen Abschirmelementen bestehen kann, den das Magnetsystem enthaltenden Kryostaten unmittelbar umgebend angeordnet ist.

Da eine Eisenabschirmung auch den Feldverlauf im Inneren des Magnetsystems beeinflußt, ist es besonders vorteilhaft, wenn die Eisenabschirmung - unter Gesichtspunkten der Wahrung einer möglichst guten Feldhomogenität im Inneren des Magnetsystems - an die verschiedenen möglichen Betriebsarten des Magnetsystems angepaßt werden kann. Hierzu sind durch die Merkmale des Anspruchs 22 vorteilhaft einfache Möglichkeiten angegeben.

Das erfindungsgemäße Magnetsystem eignet sich insbesondere für mobile Systeme, die als Gemeinschafts- oder Leihsysteme von Klinik zu Klinik oder Forschungsstelle gefahren und dort jeweils nach Einstellung auf den benötigten Betriebsmodus auf Feld gebracht - geladen - werden können.

In einer derartigen Gestaltung des Magnetsystems ist es dann vorteilhaft, wenn ein Transportbehälter des Magnetsystems oder Teile des Fahrzeuges, auf welches das Magnetsystem montiert ist, als Funktionselemente der Eisenabschirmung ausgebildet sind.

Weitere Einzelheiten und Merkmale der Erfindung ergeben sich aus der nachfolgenden Beschreibung eines speziellen Ausführungsbeispiels anhand der Zeichnung. Es zeigen:
Fig. 1 ein erfindungsgemäßes, aus zwei Feldspulen bestehendes supraleitendes Magnetsystem im Schnitt längs einer seine zentrale Längsachse enthaltenden Radialebene,
Fig. 2 das Magnetsystem gemäß Fig. 1 mit einem supraleitenden Schaltnetzwerk als Betriebsmodus-Wahlschalteinrichtung, in vereinfachter, schematischer Schaltbilddarstellung,
Fig. 3 das Magnetsystem gemäß Fig. 1 mit einer mechanischen Betriebsmodus-Wahlschalteinrichtung, in einer der Fig. 2 entsprechenden Darstellung,
Fig. 4 den Verlauf der Feldlinien (Ä x R) des von dem Magnetsystem gemäß Fig. 1 im Hochfeld-Betriebsmodus erzeugten Magnetfeldes,
Fig. 5 den Verlauf von Linien gleicher magnetischer Feldstärke im Außenraum des Magnetsystems gemäß Fig. 1 im Hochfeldbetrieb,
Fig. 6 den Verlauf der Linien gleicher Feldstärke des von dem Magnetsystem gemäß Fig. 1 in dessen Außenraum im Abschirmungsbetrieb erzeugten Feldes,
Fig. 7 den Verlauf der magnetischen Feldlinien (Ä x R) im Abschirmungsbetrieb des Magnetsystems gemäß Fig. 1, sowie
Fig. 8a und 8b zur Veranschaulichung des Homogenitätsbereiches des Magnetfeldes im Zentrum des Magnetsystems gemäß Fig. 1, für den Hochfeld-Betriebsmodus (Fig. 8a) bzw. für den Abschirmungs-Betriebsmodus (Fig. 8b), und
Fig. 9a und 9b den grundsätzlichen Aufbau einer in Verbindung mit dem Magnetsystem gemäß Fig. 1 in dessen verschiedenen Betriebsarten, auch solchen, bei denen nur eine Feldspule geladen wird, benutzbaren und an diese Betriebsarten anpaßbaren Eisenabschirmung, in einer Ansicht von der Stirnseite her (Fig. 9a) und in einer schematisch vereinfachten perspektivischen Ansicht (Fig.9b).

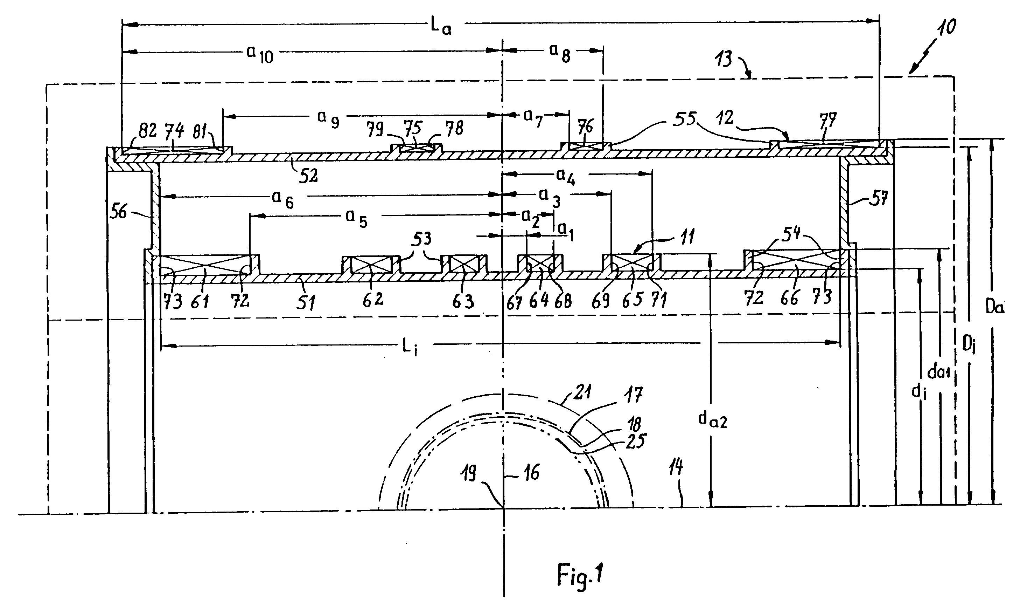

Das in der Fig. 1, auf deren Einzelheiten ausdrücklich verwiesen sei, dargestellte, insgesamt mit 10 bezeichnete erfindungsgemäße Magnetsystem ist ein aus einer inneren Feldspule 11 und einer äußeren Feldspule 12 bestehendes supraleitendes Magnetsyestem, das in einem lediglich schematisch angedeuteten Kryostaten 13 angeordnet ist, in dem die für die Supraleitfähigkeit der beiden Feldspulen 11 und 12 erforderlichen tiefen Temperaturen über längere Zeit hinweg aufrecht erhalten werden können.

Der hierfür erforderliche Aufbau des Kryostaten 13 mit einer die supraleitenden Spulen 11 und 12 aufnehmenden, mit flüssigem Helium verfüllbaren Kammer, einer die Heliumkammer allseitig umschließenden, mit flüssigem Stickstoff verfüllbaren Kammer, sowie zwischen diesen und der Außenhaut des Kryostaten angeordnete Vakuumkammern und Strahlungsschilden, kann für sich als bekannt vorausgesetzt werden und ist daher nicht im einzelnen dargestellt.

Die Feldspulen 11 und 12 und der Kryostat 13 sind bezüglich ihrer gemeinsamen zentralen Längsachse 14 rotationssymmetrisch und bezüglich der rechtwinklig zu dieser, gemäß der Darstellung der Fig. 1 senkrecht zur Zeichenebene verlaufenden Quermittelebene 16 des Magnetsystems 10 symmetrisch ausgebildet.

Die innere und die äußere Feldspule 11 bzw. 12 sind, je für sich gesehen, so gestaltet, daß sie innnerhalb relativ großer, für die jeweilige Spule 11 bzw. 12 charakteristischer, zentraler Volumbereiche 17 bzw. 18 ein parallel zur zentralen Achse 14 des Magnetsystems 10 gerichtetes, weitgehend homogenes Magnetfeld hoher Feldstärke erzeugen können, das für die Durchführung NMR-spektroskopischer und NMR-tomographischer Untersuchungen geeignet ist.

Die axiale und die radiale Ausdehnung der Homogenitätsbereiche 17 und 18, innerhalb derer der Betrag des Verhältnisses A B(r,z)ᵢ/B₀ᵢ; bzw. A B(r,z)ₐ/Bₒₐ der Abweichungen A B(r,z)i,a (i = "innen", a = "außen") der Feldstärken von den Feldstärken Bₒ,,ₐ der im Zentrum 19 von den beiden Feldspulen 11 bzw. 12 jeweils erzeugten Magnetfeldern B bzw. Bₐ höchstens einem vorgegebenen Wert von z. B. 10 ppm entspricht, sind bei unterschiedlicher Gestaltung der Feldspulen 11 und 12 im allgemeinen unterschiedlich groß. Bei dem hier dargestellten, speziellen Ausführungsbeispiel sind jedoch die Homogenitätsbereiche 17 bzw. 18 der inneren Feldspule 11 und der äußeren Feldspule 12, je für sich gesehen, näherungsweise gleich groß, da der größere Durchmesser der äußeren Feldspule 12 die geringere relative Homogenität in etwa aufwiegt.

Bei der in der Fig. 1 dargestellten Spulenkofniguration 11, 12, bei der die innere Feldspule 11 eine Spule 12. Ordnung ist, das heißt die Gradienten ihres nach Legendre'schen Polynomen entwikkelten Feldes B bis zur 11. Ordnung verschwinden, und die äußere Feldspule 12 eine Spule 8. Ordnung ist, das heißt die Gradienten ihres Feldes B bis zur 7. Ordnung verschwinden, ergibt sich für die beiden Feldspulen 11 und 12 qualitativ die dargestellte Größenrelation ihrer Homogenitätsbereiche 17 bzw. 18, welche etwa die Form von Rotations-Ellipsoiden haben, deren - gemeinsame - Rotationsachse die zentrale Längsachse 14 des Magnetsystems ist.

Bei der insoweit erläuterten Gestaltung der beiden Feldspulen 11 und 12 ist der Homogenitätsbereich 17 der inneren Feldspule 11 etwa gleich dem Homogenitätsbereich 18 der äußeren Feldspule 12.

Die beiden Feldspulen 11 und 12 sind im normalen, das heißt störungsfreien Betrieb des Magnetsystems in Reihe geschaltet und demgemäß von demselben Strom I durchflossen.

Sie sind in spezieller Relation zueinander so ausgelegt, daß die Feldstärke Bₒ; des von der inneren Feldspule 11 im Zentrum 19 des Magnetsystems 10 erzeugten Axialfeldes, dem Betrage nach, dreimal größer ist als die Feldstärke Bₒₐ des von der äußeren Feldspule 12 im Zentrum 19 des Magnetsystems 10 erzeugten Axialfeldes; des weiteren sind die beiden Feldspulen 11 und 12 hinsichtlich der geometrischen Anordnung ihrer supraleitenden Windungen so gestaltet, daß die Feldstärken der von den beiden Feldspulen 11 bzw. 12, je für sich gesehen, im Außenraum des Magnetsystems 10 erzeugten Magnetfelder, deren Feldverlauf in sehr guter Näherung jeweils demjenigen eines magnetischen Dipols entspricht, dem Betrage nach im wesentlichen gleich sind, das heißt, sich ab einem Mindestabstand R vom Zentrum 19 des Magnetsystems 10, dem Betrage nach, nur noch um einen - vernachlässigbar - geringen Wert A B-(R), der vom Abstand R vom Zentrum 19 des Magnetsystems 10 abhängig ist und mit zunehmendem Abstand R drastisch abnimmt, voneinander unterscheiden.

Hiernach sind zwei Betriebsarten des Magnetsystems 10 möglich, deren eine als "Abschirmungsbetrieb" und deren andere als "Hochfeld- Betrieb" bezeichnet werden können.

Für den Abschirmungsbetrieb werden die beiden Feldspulen 11 und 12 so bestromt, daß die von der inneren Feldspule 11 und von der äußeren Feldspule 12 erzeugten Magnetfelder zueinander entgegengesetzt gerichtet sind. Dadurch wird im Außenraum des Magnetsystems eine wirksame Kompensation der hier von den Feldspulen 11 und 12 erzeugten magnetischen Dipolfelder und im Ergebnis eine Abschirmung des von dem Magnetsystem 10 insgesamt erzeugten Magnetfeldes nach außen hin erzielt. In diesem Abschirmungsbetrieb des Magnetsystems 10 entspricht zwar der Betrag der Feldstärke des im Zentrum 19 aus der gegenseitigen Überlagerung der von den beiden Feldspulen 11 und 12 jeweils erzeugten Magnetfelder nur der Differenz der Beträge |B₀ᵢ| - IBₒₐₗ der von der inneren und der äußeren Feldspule 12 je für sich gesehen erzeugten Magnetfelder, bei dem zur Erläuterung gewählten, speziellen Ausführungsbeispiel, somit eine Feldstärke, die lediglich 2/3 der Feldstärke des von der inneren Feldspule 11 allein im Zentrum 19 erzeugten Magnetfeldes entspricht, jedoch wird eine deutliche Vergrößerung des sich im Abschirmungsbetrieb ergebenden Homogenitätsbereiches 21 erzielt. Der Abschirmungsbetrieb ist daher dann besonders günstig, wenn das Magnetsystem 10 für tomographische Zwecke eingesetzt werden soll. Im Hochfeldbetrieb erfolgt die Bestromung der Feldspulen 11 und 12 so, daß die von den beiden Feldspulen 11 und 12 je einzeln erzeugten Magnetfelder gleichsinnig gerichtet sind, d. h. sich "additiv" überlagern. Der Betrag der im Zentrum 19 des Magnetsystems 10 in dieser Betriebsart resultierenden magnetischen Feldstärke entspricht hier der Summe der Einzelbeträge |B₀ᵢ| ⁺ IBₒₐₗ der von den Feldspulen 11 und 12 je einzeln erzeugten Magnetfelder und ist somit doppelt so hoch wie im Abschirmungsbetrieb. Verglichen mit diesem muß jedoch eine Verringerung des im Hochfeldbetrieb ausnutzbaren Homogenitätsbereichs 25 hingenommen werden. Der Hochfeldbetrieb des Magnetsystems 10 ist somit dann besonders geeignet, wenn dieses für NMR-spektroskopische Zwecke eingesetzt wird.

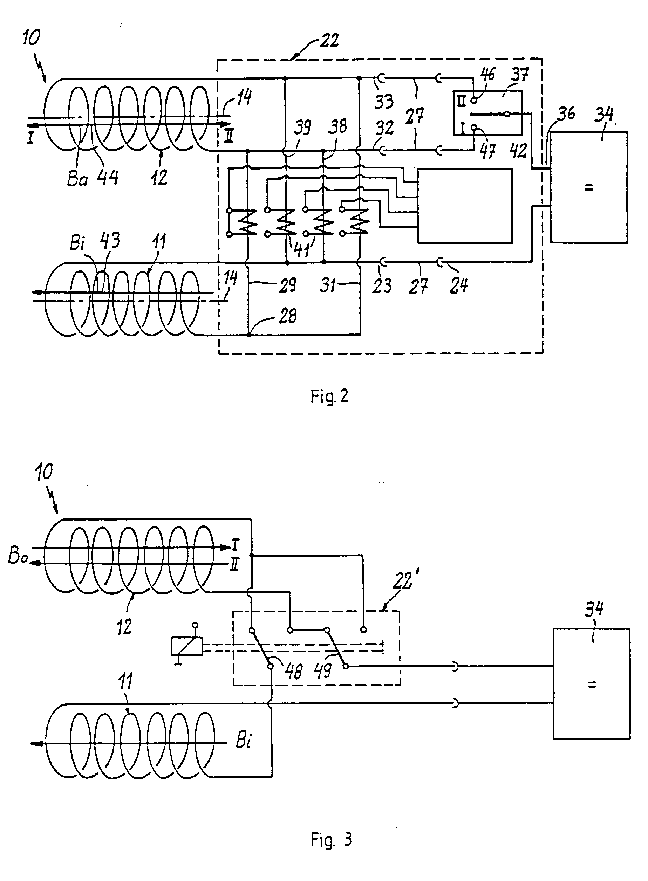

Um das Magnetsystem 10 - alternativ - in den beiden Betriebsarten betreiben zu können, ist eine in der Fig. 2, auf deren Einzelheiten nunmehr verwiesen sei, dargestellte, insgesamt mit 22 bezeichnete Betriebsmodus-Wahlschalteinrichtung vorgesehen, mittels derer das Laden der beiden Feldspulen 11 und 12 mit der für die jeweilige Betriebsart erforderlichen Flußrichtung des Suprastroms auf einfache Weise möglich ist.

In der Fig. 2 sind, der Einfachheit der Darstellung halber, die beiden Feldspulen 11 und 12, die koaxial bezüglich ihrer gemeinsamen zentralen Längsachse 14 angeordnet sind, seitlich nebeneinander liegend gezeichnet.

Die Betriebsmodus-Wahlschalteinrichtung 22 ist beim dargestellten, speziellen Ausführungsbeispiel so ausgebildet, daß die Einspeisung des Ladestromes über die äußere Feldspule 12 und die Rückführung des Ladestromes über die mit der äußeren Feldspule 12 in Reihe geschaltete innere Feldspule 11 erfolgt, deren Rückführungsanschluß 23 mit dem entsprechenden Anschluß 24 des Ladestrom-Versorgungsgerätes 26 über ein nach dem Laden der Spulen 11 und 12 abnehmbares Leiterelement 27 leitend verbunden ist.

Der Ladestrom-Zuführungsanschluß 28 der inneren Feldspule 11 ist über je einen supraleitfähigen Ladestrompfad 29 bzw. 31 mit den Versorgungs-Anschlüssen 32 und 33 der äußeren Feldspule 12 verbunden, über die - alternativ - je nach der Betriebsart, für die das Magnetsystem 10 geladen werden soll, der vom Ladegerät 34 an dessen Versorgungsausgang 36 bereitgestellte Ladestrom in das Magnetsystem 10 eingespeist wird. Die "Auswahl" der Betriebsart - Hochfeldbetrieb oder Abschirmbetrieb - des Magnetsystems erfolgt mittels eines Wahlschalters 37, der aus seiner - sperrenden - Zentralstellung in eine Funktionsstellung I schaltbar ist, in welcher der Ladestrom-Versorgungsausgang36 des Ladegeräts 34 mit dem einen, gemäß der Darstellung der Fig. 2 unteren Versorgungsanschluß 32 der äußeren Feldspule 12 leitend verbunden ist, oder in eine Funktionsstellung 11 schaltbar ist, in welcher der andere, gemäß der Darstellung der Fig. 2 obere Versorgungsanschluß 33 der äußeren Feldspule 12 mit dem Ladestrom-Ausgang 36 des Ladegeräts 34 verbunden ist.

Die Versorgungsanschlüsse 32 und 33 der Feldspule 12 sind über je einen supraleitfähigen Betriebsstrompfad 38 bzw. 39 auch mit dem Rückführungsanschluß 23 der inneren Feldspule 11 verbindbar und im stationären Betriebszustand des Magnetsystems 10 verbunden.

Die Ladestrompfade 29 und 31 und die Betriebsstrompfade 38 und 39 sind auf Abschnitten ihrer Länge mittels elektrisch ansteuerbarer Heizelemente 41 erwärmbar und dadurch aus dem supraleitenden in den resistiv-leitenden Zustand überführbar, so daß sie als elektrische Schalter betreibbar sind, die durch Einschalten der jeweiligen Heizelemente in ihren sperrenden Zustand gelangen und durch Abschalten der Heizenergie wieder in ihren supraleitenden Zustand gelangen.

Die Ladestrompfade 29 und 31 und die Betriebsstrompfade 38 und 39 bilden zusammen mit den Heizelementen 41 ein supraleitendes Schalt- Netzwerk, dessen mögliche Schaltzustände mittels eines elektronischen Steuergeräts 42, wie schematisch angedeutet, bedarfsgerecht steuerbar sind.

Das Laden des Magnetsystems 10 für dessen Abschirmungsbetrieb kann mittels der Betriebsmodus-Wahlschalteinrichtung 22 z. B. wie folgt gesteuert werden:
Nachdem das Magnetsystem 10 einschließlich seines supraleitenden Netzwerkes 29, 31, 38, 39, 41 in den supraleitenden Zustand gebracht worden ist, werden der den Versorgungsanschluß 33 der äußeren Feldspule 12 mit dem Ladestrom-Zuführungsanschluß 28 der inneren Feldspule 11 verbindende Ladestrompfad 31, der diesen Versorgungsanschluß 33 der äußeren Feldspule 12 mit dem Rückführungsanschluß 23 der inneren Feldspule 11 verbindende Betriebsstrompfad 39, sowie der den anderen Versorgungsanschluß 32 der äußeren Feldspule 12 mit dem Rückführungsanschluß 23 der inneren Feldspule 11 verbindende Betriebsstrompfad 38 mittels der diesen zugeordneten Heizelemente 41 beheizt und dadurch für einen Durchgang von Suprastrom gesperrt. Supraleitend bleibt zunächst nur der Ladestrompfad 29, welcher den Versorgungsanschluß 32 der äußeren Feldspule 12 mit dem Ladestrom-Zuführungsanschluß 28 der inneren Feldspule 11 verbindet.

Der aus dem Ladegerät 34 über den Wahlschalter 37 in das Magnetsystem 10 eingekoppelte Ladestrom, der in der Ladephase sukzessive bis auf seinen Sollwert gesteigert wird, fließt in der Ladephase über den Rückführungsanschluß der inneren Feldspule 11 zurück zum Ladegerät 34. Da die beiden Feldspulen 11 und 12, entlang ihrer - gemeinsamen - zentralen Längsachse 14 gesehen, denselben Windungssinn haben, bei der aus der Funktionsstellung 11 des Wahlschalters 37 und der Ausnutzung des Ladestrompfades 29 resultierenden Stromführung jedoch in entgegengesetzter Richtung vom Ladestrom durchflossen sind, sind die von ihnen erzeugten Felder B und Bₐ, welche durch die Pfeile 43 bzw. 44 repräsentiert sind, entgegengesetzt gerichtet.

Nachdem der Ladestrom seinen Sollwert erreicht hat, wird die Beheizung des Betriebsstrompfades 39 aufgehoben, der somit supraleitend wird und den Rückführungsanschluß 23 der inneren Feldspule 11 mit dem Versorungsanschluß 33 der äußeren Feldspule 12 verbindet, über den die Ladung des Magnetsystems 10 für den Abschirm-Betriebsmodus erfolgt war. Das Ladegerät 34 ist jetzt durch diesen Betriebsstrompfad überbrückt und der den Abschirmungsbetrieb des Magnetsystems 10 vermittelnde supraleitende Betriebsstromkreis geschlossen. Sobald dies der Fall ist, wird auch die Beheizung des Betriebsstrompfades 38, der den Rückführungsanschluß 23 der inneren Feldspule 11 mit dem bei der Ladung nicht ausgenutzten Versorgungsanschluß 32 der äußeren Feldspule 12 verbindet, aufgehoben sowie diejenige des Ladestrompfades 31, der bei der vorstehend erläuterten Art der Ladung nicht ausgenutzt war, so daß auch diese Strompfade supraleitend werden. Hiernach kann durch Entfernen der Leiterelemente 27, über die im Ladebetrieb der Festkontakt 46 des Wahlschalters 37 mit dem Versorgungsanschluß 33 der äußeren Feldspule 12 und der Rückführungsanschluß 24 des Ladegeräts 34 mit dem Rückführungsanschluß 23 der inneren Feldspule 11 verbunden waren, das supraleitende Magnetsystem 10 vom - resistiven - Versorgungsteil abgekoppelt werden.

Die Ladung des Magnetsystems 10 für den Hochfeld-Betriebsmodus erfolgt in der Funktionsstellung 1 des Wahlschalters, wobei nunmehr während des Ladens der Ladestrompfad 31 supraleitend gehalten ist, der den Ladestrom-Zuführungsanschluß 28 der inneren Feldspule 11 mit dem Versorgungsanschluß 33 der äußeren Feldspule 12 verbindet, wogegen der Ladeabschnitt 29 und die Betriebsstrompfade 38 und 39 in der Ladephase beheizt sind und daher im resistiven, einen Suprastrom sperrenden Zustand gehalten bleiben. Der Ladestrom fließt somit vom Ausgang 36 des Ladegeräts 34 über den in der Funktionsstellung I befindlichen Wahlschalter 37 zu dem Versorgungsanschluß 32 der äußeren Feldspule 12, über diese und den supraleitend gehaltenen Ladestrompfad 31 zum Ladestrom-Zuführungsanschluß 28 der inneren Feldspule 11 und über diese zurück zum Ladegerät 34. Nachdem der in dem Magnetsystem 10 fließende Suprastrom seine Sollstärke erreicht hat, wird die Beheizung des Betriebsstrompfades 38 aufgehoben, der hiernach in den supraleitenden Zustand gelangt und nunmehr, das Ladegerät 34 überbrückend, den Stromkreis innerhalb des supraleitenden Systems schließt. Danach wird auch die Beheizung des Betriebsstrompfades 39 und des Ladestrompfades 29 aufgehoben. Sobald diese beiden Strompfade 39 und 29 ebenfalls supraleitend geworden sind, kann das Magnetsystem 10 durch Entfernen des den Rückführungsanschluß 23 der inneren Feldspule 11 mit dem Rückführungsanschluß 24 des Ladegeräts 34 verbindenden Leiterelements 27 sowie des den hier ausgenutzten Versorgungsanschluß 32 der äußeren Feldspule 12 mit dem Festkontakt 47 des Wahlschalters 37 im Ladebetrieb verbindenden Leiterelementes 27 von der Versorgungsseite elektrisch abgekoppelt werden.

Liegt in der äußeren Feldspule 12 ein Defekt vor, so kann das Magnetsystem 10 weiterhin mit der allein noch funktionsfähigen inneren Feldspule 11 betrieben werden. Diese ist dann in der Stellung 11 des Wahlschalters 37 über den im supraleitenden Zustand gehaltenen Ladestrompfad 31 ladbar und kann dadurch, daß der Betriebsstrompfad 39 in seinen supraleitenden Zustand gebracht wird, kurzgeschlossen werden, so daß ein in der inneren Feldspule 11 zirkulierender Suprastrom erzielt werden kann. Auch in der Stellung 1 des Wahlschalters 37 kann in dem genannten Fehlfunktionsfall der äußeren Feldspule 12 die innere Feldspule 11 über den im supraleitenden Zustand befindlichen Ladestrompfad 29 geladen werden und über den in seinen supraleitenden Zustand übergeführten Betriebsstrompfad 38 kurzgeschlossen werden.

Tritt andererseits ein Defekt in der inneren Feldspule 11 auf, so kann das Magnetsystem 10 auch allein mit seiner äußeren Feldspule 12 betrieben werden. Diese ist dann in der Stellung 11 des Wahlschalters 37 über den im supraleitenden Zustand gehaltenen Betriebsstrompfad 38 ladbar und kann über den während des Ladens gesperrten, danach in seinen supraleitenden Zustand übergeführten Betriebsstrompfad 39 kurzgeschlossen werden. Auch in der Stellung 1 des Wahlschalters 37 ist die äußere Feldspule 12 ladbar, in diesem Falle über den im supraleitenden Zustand befindlichen Betriebsstrompfad 39 und kann über den während des Ladens im gesperrten Zustand gehaltenen Betriebsstrompfad 38, durch Überführung desselben in seinen supraleitenden Zustand, kurzgeschlossen werden.

Es versteht sich, daß ein supraleitendes Magnetsystem mit den vorstehend erläuterten funktionellen Eigenschaften auch in der Weise realisiert werden kann, daß die äußere und die innere Feldspule mit entgegengesetztem Windungssinn gewikkelt sind. Eine derartige Gestaltung des Magnetsystems vorausgesetzt, ergibt eine Ladung desselben wie vorstehend für den Hochfeld-Betriebsmodus erläutert, den für den Abschirmbetrieb des Magnetsystems geeigneten Stromfluß, während eine Ladung wie für den Abschirm-Betriebsmodus vorstehend erläutert die für den Hochfeld-Betriebsmodus geeignete Stromführung ergibt.

Der Wahlschalter 37 mit der vorstehend erläuterten, speziellen Funktion ist dann nicht notwendig, wenn es auf die Polarität der von den beiden Feldspulen 11 und 12 erzeugten Felder nicht ankommt, d. h. lediglich gewährleistet sein muß, daß diese Felder im Abschirmungsbetrieb die entgegengesetzte und im Hochfeldbetrieb des Magnetsystems 10 diesselbe Polarität haben.

Das in der Fig. 3, auf deren Einzelheiten nunmehr verwiesen sei, dargestellte Magnetsystem 10 unterscheidet sich von demjenigen gemäß Fig. 2 in konstruktiver Hinsicht lediglich durch die Gestaltung der Betriebsmodus-Wahlschalteinrichtung 22', die hier als ein einfaches entweder elektrisch steuerbares Umschlatrelais oder als ein von Hand betätigbarer Mehrkontakt-Schalter mit mechanisch-beweglichen Schaltkontakten 48 und 49 ausgebildet ist, in funktioneller Hinsicht dadurch, daß das Ladegerät 34 auch während des Untersuchungs- oder Experimentier-Betriebes des Magnetsystems 10 an dieses angeschlossen bleiben muß.

Der Schalter 22' ist zwischen zwei Funktionsstellungen 1 und II umschaltbar, wobei die in ausgezogener Liniendarstellung der Schaltkontakte 48 und 49 wiedergegebene Funktionsstellung II dem Hochfeld-Betriebsmodus, die in gestrichelter Darstellung der Schaltkontakte 48 und 49 wiedergegebene Funktionsstellung 1 dem Abschirm-Betriebsmodus des Magnetsystems 10 zugeordnet sind.

Die in der Fig. 3 dargestellte Gestaltung der Betriebsmodus-Wahlschalteinrichtung 22' ist sowohl für ein supraleitendes Magnetsystem 10 als auch für ein Magnetsystem mit resistiven Feldspulen 11 und 12 geeignet.

Die mit den verschiedenen Betriebsarten 1 und II verknüpften Richtungen der von der äußeren Feldspule 12 erzeugten Bₐ-Felder sind entsprechend mit 1 und II bezeichnet.

Zur Erläuterung einer speziellen Gestaltung des Spulensystems 10 sei nunmehr wieder auf die diesbezüglichen Einzelheiten der Fig. 1 Bezug genommen, die in einer maßstäblichen LängsschnittDarstellung die Gestaltung der inneren und äußeren Feldspulen 11 und 12 wiedergibt.

Die innere Feldspule 11 besteht aus insgesamt sechs Teilwicklungen 61 - 66, die sich, je für sich gesehen, nur über einen Bruchteil der axialen Gesamtlänge L_{;} der inneren Feldspule 11 erstrecken und in der Reihenfolge ihrer Bezugsziffern elektrisch in Reihe geschaltet sind.

Diese Teilwicklungen 61 bis 66 haben, in der Schnittebene der Fig. 1 gesehen, einen rechteckigen Querschnitt. Die Teilwicklungen 61 bis 66 der inneren Feldspule 11 haben jeweils denselben Innendurchmesser dᵢ.

Die beiden äußeren Feldwicklungen 61 und 66 der inneren Feldspule 11 haben einen Außendurchmesser dₐᵢ, der etwas größer ist als der Außendurchmesser der innersten Teilwicklungen 63 und 64 und derjenige der zwischen diesen und den äußeren Feldwicklungen 61 und 66 angeordneten - mittleren - Teilwicklungen 62 und 65, wobei diese mittleren Teilwicklungen 62 und 65 und die inneren Teilwicklungen 63 und 64 denselben Außendurchmesser dₐ₂ haben.

Die inneren Stirnseiten 67 der inneren Teilwicklungen 63 und 64 haben von der Symmetrieebene 16 den axialen Abstand aᵢ , ihre äußeren Stirnseiten 68 den Abstand a₂.

Die inneren Stirnseiten 69 der mittleren Teilwicklungen 62 und 65 der inneren Feldspule 11 haben von deren Symmetrieebene den axialen Abstand a₃, ihre äußeren Stirnseiten 71 den axialen Abstand a₄.

Die inneren Stirnseiten 72 der äußeren Teilwicklungen 61 und 66 haben von der Symmetrieebene 16 des Magnetsystems 10 den axialen Abstand aₛ. Der axiale Abstand a₆ der äußeren Stirnseite 73 der äußeren Teilwicklungen 61 und 62 der inneren Feldspule 11 entspricht deren halber Länge Lᵢ/2.

Die äußere Feldspule 12 besteht aus insgesamt vier Teilwicklungen 74 bis 77, welche, in der Reihenfolge ihrer Bezugsziffern 74, 75, 76, 77 elektrisch in Reihe geschaltet sind, sich jeweils nur über einen Teil der Gesamtlänge Lₐ der äußeren Feldspule 12 erstrecken und, in der Darstellung der Fig. 1 gesehen, einen rechteckigen Querschnitt haben.

Der axiale Abstand der inneren Stirnseiten 78 der inneren Teilwicklungen 75 und 76 von der Symmetrieebene 16 des Magnetsystems 10 hat den Wert a₇.

Der axiale Abstand der äußeren Stirnseite 79 der inneren Teilwicklungen 75 und 76 von der zentralen Symmetrieebene 16 des Magnetsystems 10 hat den Wert a₈.

Der axiale Abstand der inneren Stirnseiten 81 der äußeren Teilwicklungen 74 und 77 der äußeren Feldspule 12 von deren Symmetrieebene 16 hat den Wert ag. Der axiale Abstand a₁₀ der äußeren Stirnseite 82 der äußeren Teilwicklungen 74 und 77 der äußeren Feldspule 12 von deren zentraler Symmetrieebene 16 entspricht dem halben Wert Lₐ/2 der Gesamtlänge Lₐ der äußeren Feldspule 12.

Die äußeren Teilwicklungen 74 und 77 der äußeren Feldspule 12 haben je 2 832 Windungen. Die inneren Teilwicklungen 75 und 76 der äußeren Feldspule 12 haben je 1 056 Windungen. Diese Windungen der äußeren und inneren Teilwicklungen 74, 77 und 75, 76 der äußeren Feldspule 12 sind in jeweils 16 radial übereinander liegenden Windungslagen angeordnet.

Die äußeren Teilwicklungen 61 und 66 der inneren Feldspule 11 haben jeweils 5 304 Windungen, die in 34 Windungslagen radial übereinander angeordnet sind. Die mittleren Teilwicklungen 62 und 65 der inneren Feldspule 11 haben jeweils 1 960 Windungen, die in 28 Windungslagen radial übereinander angeordnet sind.

Die inneren Teilwicklungen 63 und 64 der inneren Feldspule 11 haben jeweils 1 456 Windungen, die ebenfalls in 28 Windungslagen radial übereinander angeordnet sind.

Die Teilwicklungen 61 bis 66 der inneren Feldspule 11 und die Teilwicklungen 74 bis 77 der äußeren Feldspule 12, die insgesamt elektrisch in Reihe miteinander geschaltet sind, sind so gestaltet, daß sich im Betrieb des Magnetsystems 10 für beide Feldspulen 11 und 12 dieselbe Stromdichte I/cm² ergibt.

Die Teilwicklungen 61 bis 66 der inneren Feldspule 11 und die Teilwicklungen 74 bis 77 der äußeren Feldspule 12, sind auf je einen der Grundform nach zylindrich-rohrförmigen Spulenträger 51 bzw. 52 aufgewickelt. Die spulenträger 51 und 52 sind an ihren Außenseiten mit radialen Ringflanschen 53 und 54 bzw. 55 versehen, welche paarweise die axialen Begrenzungen von Wicklungkästen bilden, in denen die Teilwicklungen 61 bis 66 der inneren Feldspule 11 bzw. die Teilwicklungen 74 bis 77 der äußeren Feldspule 12 axial unverrückbar gehalten und radial nach innen abgestützt sind. Die beiden im wesentlichen rohrförmigen Spulenträger 51 und 52 sind an ihren Stirnseiten durch im wesentlichen ringförmige Stirnscheiben 56 und 57 mechanisch fest miteinander verbunden. Die Spulenträger 51 und 52 und die Stirnscheiben 56 und 57 sind üblicherweise aus Aluminium gefertigt. Die Trag- und Haltekonstruktion, mittels derer das Magnetsystem 10 im Inneren des Kryostaten 13 fest montiert ist, ist, der Einfachheit der Darstellung halber, nicht gezeigt. In einer speziellen Auslegung des Spulensystems 10 mit der inneren Feldspule 11 als Spule 12. Ordnung und der äußeren Feldspule 12 als Spule 8. Ordnung haben deren geometrische Parameter a₁ bis a₁₀ sowie dₐ₁, dₐ₂ sowie Dᵢ und Dₐ die folgenden Werte:
a₁ : 6,43 cm
a₂: 14,24 cm
a₃: 28,99 cm
a₄: 39,57 cm
as: 66,13 cm
a₆ : 89,50 cm
a₇: 17,77 cm
a₈: 25,65 cm
a₉ : 73,50 cm
a₁₀: 100,00 cm
dᵢ: 61,43 cm
dₐ₁: 66,53 cm
dₐ₂: 65,63 cm
D_{;}: 91,93 cm
Dₐ: 94,33 cm
   Das Magnetsystem 10 mit dieser - geometrischen - Auslegung seiner Feldspulen 11 und 12 wird in einem typischen Einsatzfall mit einer Stromdichte von 8 333 A/cm² betrieben. Bei den oben angegebenen Windungen und Windungslagen ergibt sich für das Magnetsystem 10 eine Betriebsstromstärke von 187,5 A.

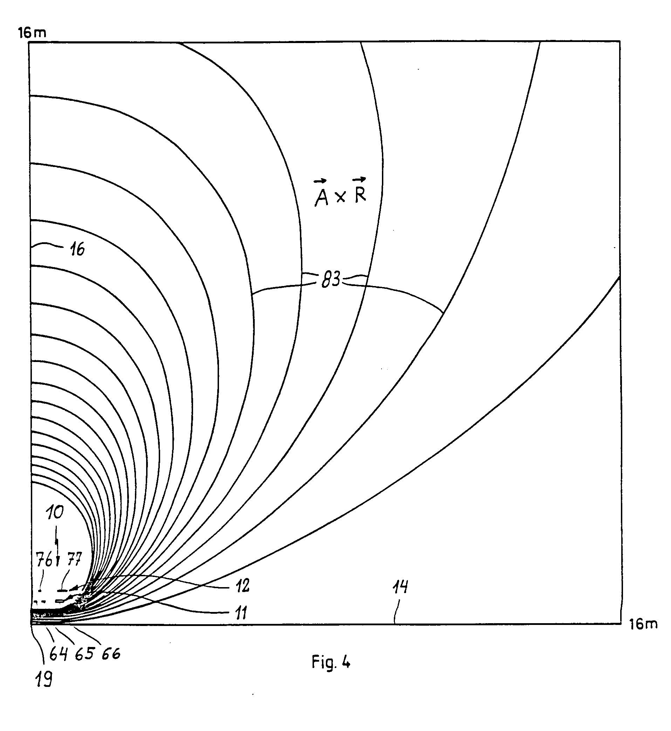

Unter diesen Betriebsbedingungen erzeugt das Magnetsystem 10 ein B-Feld mit dem qualitativ in der Fig. 4, auf deren Einzelheiten nunmehr verwiesen sei, dargestellten Verlauf der B-Feldlinien 83, deren Verlauf im Außenraum des Magnetsystems 10 in erster Näherung demjenigen eines magnetischen Dipolfeldes entspricht, während im Innenraum des Magnetsystems 10 das heißt innerhalb der Länge L_{;} der inneren Feldwicklung 11 die Feldlinien annähernd parallel zur zentralen Längsachse 14 des Magnetsystems 10 verlaufen. Der Einfachheit der Darstellung halber ist in der Fig. 4 lediglich der "1." Quadrant des Feldverlaufes (A̅ x R̅) in einer die zentrale Achse 14 des Magnetsystems 10 enthaltenden, rechtwinklig zur Symmetrieebene 16 des Magnetsystems 10 verlaufenden Ebene dargestellt, wobei die vom Zentrum 19 des Magnetsystems 10 aus gemessene axiale und radiale Ausdehnung des dargestellten Bereiches jeweils 16 m beträgt.

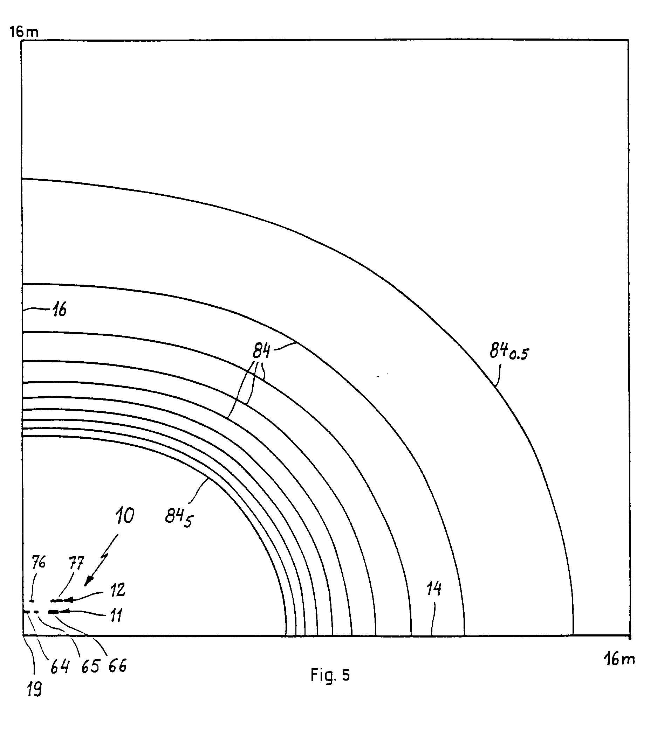

Für den Hochfeld-Betrieb des Magnetsystems 10 ist weiter in der Fig. 5, auf deren Einelheiten ergänzend Bezug genommen sei, der sich im Außenraum des Magnetsystems 10 ergebende Verlauf der Linien 84 gleicher Feldstärke ("Äquifeldlinien") dargestellt, die etwa den Konturen von Ellipsen entsprechen, welche die Symmetrieebene 16 des Magnetsystems 10 und dessen zentrale Achse 14 jeweils rechtwinklig schneiden. Gemäß der maßstäblichen Darstellung der Fig. 5 schneidet die einer Feldstärke von 5 mT entsprechende Äquifeldlinie 84₅ die Symmetrieebene 16 des Magnetsystems 10, vom Zentrum 19 des Magnetsystems 10 aus gemessen, in einem radialen Abstand von 5,4 m und die zentrale Achse 14 des Magnetsystems 10 in einem axialen Abstand von 6,8 Die 1/10 dieser Feldstärke entsprechende Äquifeldlinie 84₀,₅ schneidet die Symmetrieebene 16 des Magnetsystems 10 in einem radialen Abstand von 12 mund die zentrale Längsachse 14 des Magnetsystems 10 in einem axialen Abstand von 14,5 m.

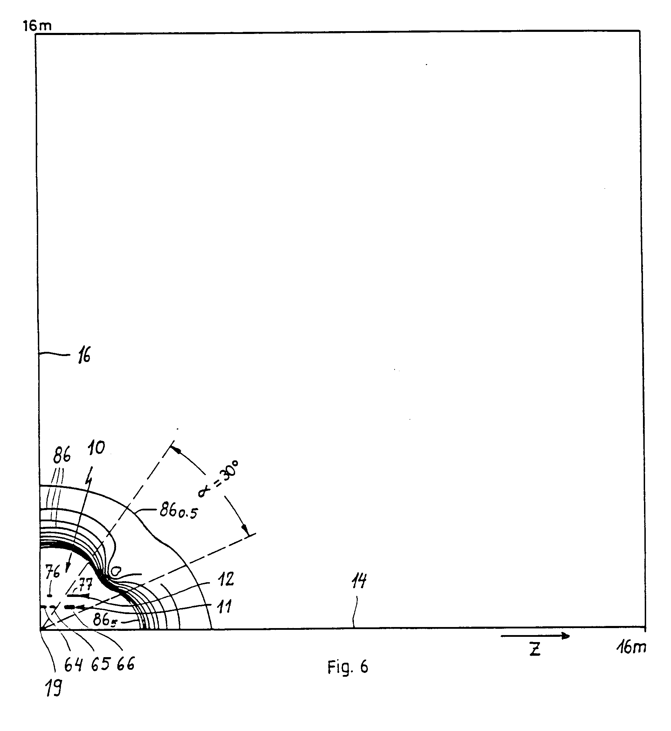

In der Fig. 6, auf deren Einzelheiten nunmehr Bezug genommen sei, ist in einer der Fig. 5 - auch maßstäblich - entsprechenden Darstellung der Verlauf der Äquifeldlinien 86 für den Abschirmungsbetrieb des Magnetsystems 10 dargestellt, für den sich im Zentrum 19 des Magnetsystems 10 eine Feldstärke von 1 Tesla ergibt.

Die 5 mT-Äquifeldlinie 86₅ schneidet hier die Symmetrieebene 16 des Magnetsystems 10 in einem radialen Abstand von etwa 2,3 m vom Zentrum 19 des Magnetsystems 10 und die zentrale Längsachse 14 in einem Abstand von 2,5 m, während die einer Feldstärke von 0,5 mT entsprechende Feldlinie 86₀,₅ die Symmetrieebene 16 des Magnetsystems 10 in einem radialen Abstand von 3,9 m und die zentrale Längsachse 14 des Magnetsystems 10 in einem axialen Abstand von 4,4 m, jeweils vom Zentrum 19 aus gemessen, schneidet. Innerhalb eines vom Zentrum 19 des Magnetfeldes 10 aus gesehen sektorförmigen Winkelbereiches a von etwa 30°, der, von der zentralen Längsachse 24 aus gemessen zwischen 25 und 55 liegt, haben die Äquifeldlinien 86 einen - in der Darstellungsebene gesehen - von einem elliptischen deutlich abweichenden, zum Zentrum 19 des Magnetsystems 10 hin eingebuchteten Verlauf, wobei der Bereich, innerhalb dessen die Feldstärke des Magnetfeldes auf den Wert von 0,5 mT abfällt, deutlich, das heißt etwa um den Faktor 1/3 kleiner ist als im Hochfeld-Betriebsmodus des Magnetsystems 10.

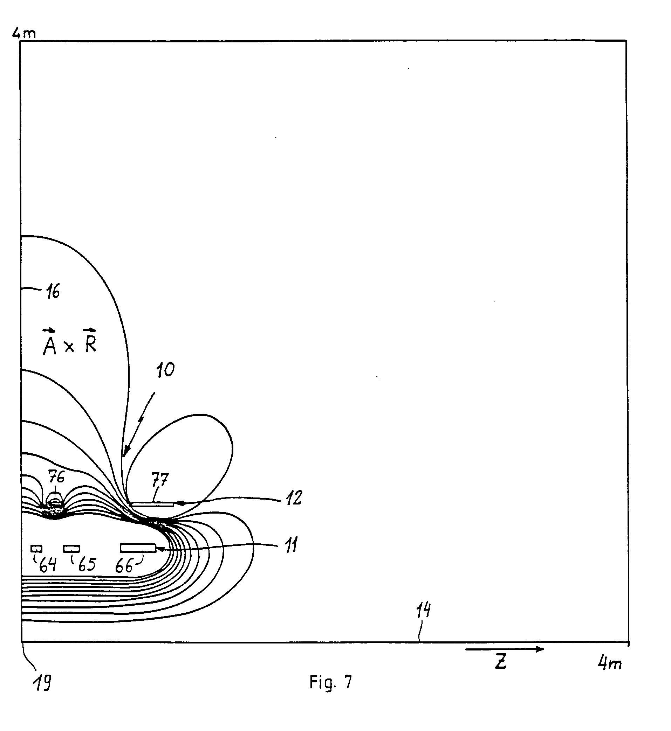

Dies rührt daher, daß im Abschirmungsbetrieb des Magnetsystems 10 das von diesem erzeugte Magnetfeld, dessen Feldlinienverlauf (Ä x R) in der Fig. 7, auf deren Einzelheiten nunmehr Bezug genommen sei, in einer der Fig. 4 entsprechenden, im Maßstab jedoch um den Faktor 4 vergrößerten Darstellung wiedergegeben ist, größtenteils "innerhalb", d. h. "zwischen" der inneren Feldspule 11 und der äußeren Feldspule 12 geschlossen wird und Streufelder nur noch in wesentlich geringerem Maße in den Außenraum des Magnetsystems 10 austreten können.

Soweit in den Fig. 4 bis 7 Bezugszeichen angegeben sind, die in den diesbezüglichen Teilen der Beschreibung nicht eigens erwähnt sind, soll dies den Verweis auf die Beschreibung der vorstehend identisch bezeichneten Elemente des Magnetsystems 10 bedeuten.

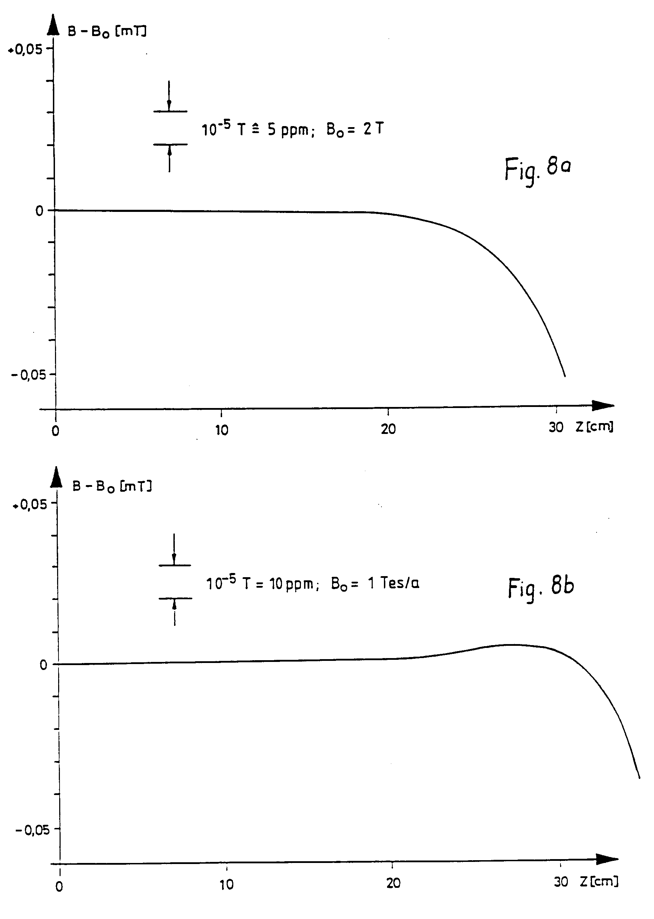

In den Fig. 8a und 8b, auf deren Einzelheiten nunmehr Bezug genommen sei, ist für den Hochfeld-Betriebsmodus (Fig. 8a) und den Abschirmungsbetrieb (Fig. 8b) des Magnetsystems 10 der Verlauf der Abweichung A B = B - Bo der Feldstärke B des von dem Magnetsystem 10 erzeugten B-Feldes von dem Wert Bₒ der Feldstärke im Zentrum 19 des Magnetsystems 10 in Abhängigkeit von dem entlang der zentralen Achse 14 gemessenen Abstand Z vom Zentrum 19 dargestellt.

Wie aus dem Vergleich der Fig. 8a und 8b unmittelbar erkennbar, ist der axiale Bereich, innerhalb dessen sich die Feldstärke B um weniger als 10 ppm von der im Zentrum herrschenden Feldstärke Bₒ unterscheidet, im Falle des Hochfeldbetriebes also um weniger als 2-10-5 T, im Falle des Abschirmungsbetriebes um weniger als 10-⁵ T (Bo = 1 T) verschieden ist, im Falle des Abschirmungsbetriebes deutlich, das heißt um etwa 20 % größer als im Hochfeldbetriebs des Magnetsystems 10.

Diese unterschiedliche Homogenität ergibt sich aus dem von verschiedenen Koeffizienten 8. Ordnung der äußeren Feldspule 12, der negativ ist. Im Abschirmungsbetrieb, in dem die äußere Feldspule 12 mit negativem Strom beaufschlagt ist, führt der Beitrag 8. Ordnung zu einer vorteilhaften Vergrößerung des Homogenitätsbereiches entlang der Rotationsachse sowie in der dazu senkrechten Spiegelebene 16 in radialer Richtung.

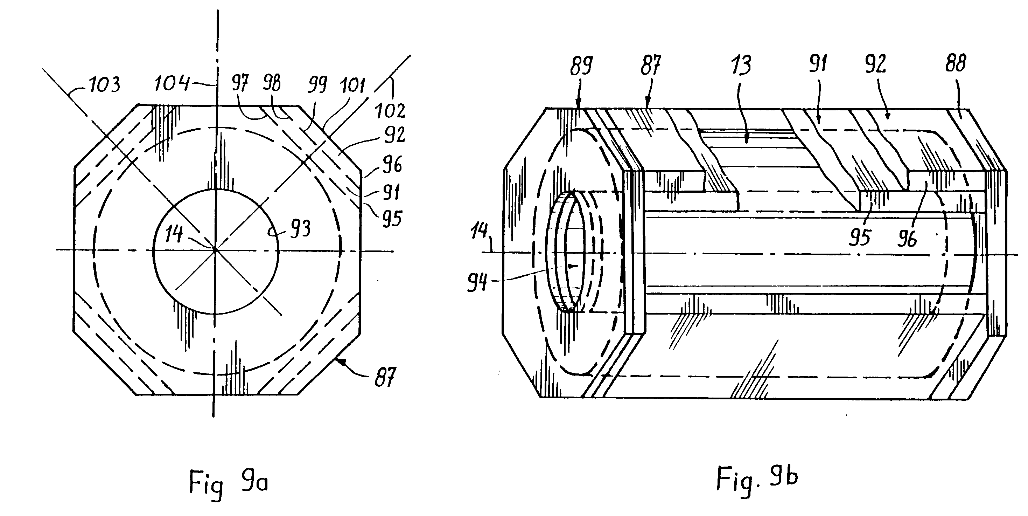

Anhand der Fig. 9a und 9b, auf deren Einzelheiten ausdrücklich verwiesen sei, werden abschließend einfache Gestaltungsmöglichkeiten einer insgesamt mit 87 bezeichneten Eisenabschirmung erläutert, die beispielsweise auch dann eine Abschirmung des von dem Magnetsystem 10 ansonsten im Außenraum erzeugten Magnetfeldes vermittelt, wenn das Magnetsystem 10 im Hochfeldbetrieb benutzt wird. Dasselbe gilt sinngemäß, wenn das Magnetsystem 10 mit nur einer seiner beiden Feldspulen 11 oder 12 betrieben wird.

Diese Abschirmung 87 ist bezüglich ihrer zentralen Längsachse 14, die in der Gebrauchslage der Abschirmung 87 mit der zentralen Achse 14 des Magnetsystems 10 zusammenfällt, in vierzähliger Symmetrie ausgebildet. Die Abschirmung 87 besteht aus senkrecht zur zentralen Längsachse 14 verlaufenden Stirnplatten 88 und 89 und diese miteinander verbindenden, parallel zur zentralen Längsachse 14 verlaufenden balkenförmigen Abschirmelementen 91 und 92 aus Eisen, die z.B. durch nicht dargestellte Verschraubungen lösbarfest mit einander verbunden sind. Die Stirnplatten 88 und 89 haben kreisrunde, zentrale Öffnungen 93, deren Durchmesser dem Durchmesser der zentralen Bohrung 94 des Kryostaten 13 entspricht, der das Magnetsystem 10 enthält.

Die balkenförmigen Abschirmelemente 91 und 92 sind als Eisenplatten mit trapezförmigem Querschnitt ausgebildet, deren seitliche Schenkelflächen 95 bzw. 96 unter 45 _{°} zu den Basisflächen 97 und 98 bzw. 99 und 101 der gemäß der Darstellung der Fig. 9a und 9b inneren balkenförmigen Abschirmelemente 91 bzw. der äußeren balkenförmigen Abschirmelemente 92 verlaufen, wobei die balkenförmigen Abschirmelemente 91 und 92 so angeordnet sind, daß ihre in Richtung der zentralen Längsachse 14 verlaufenden und sich entlang dieser schneidenden Längsmittelebenen 102 und 103 mit der vertikalen Längsmittelebene 104 des das Magnetsystem 10 und die Eisenabschirmung 87 umfassenden Gesamtsystems jeweils einen Winkel von 45 ° einschließen.

Die Eisenabschirmung 87 ist so gestaltet, daß die Stirnplatten 88 und 89 in unmittelbarer Nähe der ringförmigen Stirnflächen des Mantels des Kryostaten 13, gegebenefalls an diesen sogar anliegend angeordnet werden können, und daß auch der radiale Abstand der inneren balkenförmigen Abschirmelemente 91 von der äußeren Mantelfläche des Kryostatenmantels gering ist, d. h. einige Zentimeter beträgt, so daß die Eisenabgchirmung 87 den Kryostaten 13, in dessen Umfangsrichtung gesehen abschnittsweise, unmittelbar umgibt.

Durch eine zweckgerechte Berücksichtigung der Eisenabschirmung 87 auf den Feldverlauf im Inneren des Magnetsystems 10 kann für dessen Hochfeldbetrieb eine Verbesserung der Feldhomogenität erreicht werden. Dasselbe gilt sinngemäß auch für den Fall, daß das Magnetsystem nur mit einer seiner beiden Feldspulen 11 oder 12 betrieben wird, wobei dann die Eisenabschirmung allerdings an den jeweiligen Betrieb anpaßbar sein muß, um optimale Feldhomogenität zu erzielen.

Diesbezügliche Anpassungsmöglichkeiten sind bei der Eisenabschirmung 87 dadurch gegeben, daß z. B. die äußeren balkenförmigen Abschirmelemente 92 entfernt werden können und/oder daß die effektive Dicke der Stirnplatten 88 und 89 durch Entfernen oder Ansetzen einer weiteren Stirnplatte, wie im linken Teil der Fig. 9b durch eine zweiteilige Stirnplatte 89 schematisch angedeutet, variierbar ist. Dabei versteht es sich, daß solche Stirnplattenelemente nicht, wie in der Fig. 9b dargestellt, diesselbe Plattenfläche und Umfangskontur haben müssen, sondern gegebenenfalls auch als runde Scheiben ausgebildet sein können, deren Außendurchmesser deutlich kleiner ist als der zwischen parallelen Konturenkanten gemessene Durchmesser der dargestellten Stirnplatten.

Es versteht sich, daß die dargestellten Möglichkeiten der Gestaltung einer in Verbindung mit dem Magnetsystem 10 benutzbaren Eisenabschirmung 87 nicht erschöpfend sein können, daß es dem Fachmann aber bei Kenntnis des geschilderten Grundprinzips einer variabel-anpaßbaren Eisenabschirmung ohne weiteres möglich ist, deren bedarfsgerechte Gestaltung im Wege der Berechnung und/oder der Erprobung zu bestimmen.

In spezieller, der Einfachheit halber nicht dargestellter Gestaltung ist das Magnetsystem 10, gegebenenfalls einschließlich einer vorstehend erläuterten Eisenabschirmung 87, als eine transportable Einheit ausgebildet, die mittels eines Fahrzeuges an den jeweiligen Einsatzort transportierbar ist, z.B. zu einer Klinik, wo das Magnetsystem 10 vorwiegend zu tomographischen Zwecken eingesetzt werden wird, oder zu einem Forschungsinstitut, wo es in erster Linie zu spektroskopischen Zwecken eingesetzt werden kann.

Hierbei ist es in spezieller Gestaltung eines solchen transportablen Magnetsystems 10 vorteilhaft, wenn dieses, einschließlich des Ladegeräts, fest auf das Transportfahrzeug montiert ist, wobei Teile des Transportfahrzeuges als Funktionselemente der Eisenabschirmung des Magnetsystems ausgenutzt werden. In einer solchen, einen vielfältigen Einsatz ermöglichenden Gestaltung des Magnetsystems 10 ist dieses als Gemeinschafts- oder Leihsystem geeignet, das sowohl für den Betreiber, als auch für den Benutzer einen sehr wirtschaftlichen Einsatz ermöglicht.

## Patentansprüche

1. Magnetsystem (10) mit supraleitenden Feldspulen zur Erzeugung eines für NMR-Untersuchungen geeigneten Magnetfeldes, das im Untersuchungsvolumen eine hohe Feldstärke und eine für NMR-Experimente, tomographische und/oder spektroskopische Untersuchungen hinreichende Homogenität hat, mit zwei koaxial bezüglich der durch die Feldrichtung im Homogenitätsbereich ausgezeichneten Längsachse (14) des Systems angeordneten Spulensystemen (11,12) unterschiedlichen mittleren radialen Durchmessers, welche rotationssymmetrisch ausgebildet und symmetrisch zu der zur Längsachse (14) normalen Quermittelebene (16) des Systems angeordnet sind und mit Erregerströmen beaufschlagbar sind, aus denen sich überlagernde Magnetfelder resultieren, die im Außenraum des Magnetsystems die Kompensation der Dipolfelder beider Spulensysteme zumindest annähernd vermitteln, dadurch gekennzeichnet, daß eine Betriebsmodus-Wahlschalteinrichtung (22) vorgesehen ist, mittels der das Magnetsystem (10) alternativ zu der die - weitgehende - Dipolfeldkompensation im Außenraum des Magnetsystems (10) vermittelnden Betriebsart auch auf mindestens diejenige Betriebsart umschaltbar ist, in welcher die von den beiden Spulensystemen ( 11 und 12 ) im Zentrum derselben erzeugten magnetischen Felder gleichgerichtet sind.

2. Magnetsystem nach Anspruch 1,
dadurch gekennzeichnet, daß das Verhältnis _{Bo;loa} der Beträge der Feldstärken B_{o;} und Boa der von der radial inneren Feldspule (11) und der radial äußeren Feldspule (12) im Zentrum (19) des Magnetsystems (10) erzeugten Axial-Felder nährungsweise den Wert 3 hat.

3. Magnetsystem nach Anspruch 1 oder Anspruch 2,
dadurch gekennzeichnet, daß die radial innere Feldspule (11) eine Spule von mindestens 8. Ordnung, vorzugsweise eine Spule von 12. Ordnung und die radial äußere Feldspule (12) eine Spule von mindestens 6. Ordnung, vorzugsweise 8. Ordnung ist.

4. Magnetsystem nach Anspruch 3, dadurch gekennzeichnet, daß die radial äußere Feldspule (12) mindestens 4, in Richtung der zentralen Achse (14) des Magnetsystems (10) gesehen, in axialen Abständen voneinander angeordnete, vom Erregerstrom gleichsinnig durchflossene Teilwicklungen (74 bis 77) gleicher Windungsdichte umfaßt, welche vorzugsweise denselben radialen Innendurchmesser Dᵢ und denselben radialen Außendurchmesser Dₐ haben, wobei die Windungszahlen der axial äußeren Wicklungen (74 und 77) zwischen 2,5 und 3,5 mal größer sind als diejenigen der axial inneren Wicklungen (75 und 76) und die radiale Dicke (Dₐ - Dᵢ) der Teilwicklungen (74 bis 77) klein ist gegen den mittleren radialen Durchmesser (Dₐ + Di)/2 und zwischen 2% und 4% desselben beträgt.

5. Magnetsystem nach Anspruch 3 oder Anspruch 4, dadurch gekennzeichnet, daß die radial innere Feldspule (11) mindestens 6, in Richtung der zentralen Achse (14) des Magnetsystems (10) gesehen, in axialen Abständen voneinander angeordnete, vom Erregerstrom gleichsinnig durchflossene Teilwicklungen (61 bis 66) gleicher Windungsdichte umfaßt, welche vorzugsweise denselben radialen Innendurchmesser dᵢ haben, wobei die Windungszahl der zwischen den jeweils axial inneren Wicklungen (63 bzw. 64) und den axial äußeren Wicklungen (61 bzw. 66) angeordneten mittleren Wicklungen (62 bzw. 65) zwischen 1,3 und 1,6 mal größer ist als diejenige der axial inneren Wicklungen (63 bzw. 64) und die Windungszahlen der axial äußeren Wicklungen (61 und 62) zwischen 3,5 und 4 mal größer sind als diejenige der axial inneren Wicklungen (63 bzw. 64), wobei weiter die radialen Dicken (dₐ₂ - dᵢ) der axial inneren und der mittleren Wicklungen (63 und 64 bzw. 62 und 65) und die radialen Dicken (dₐᵢ - dᵢ) der axial äußeren Wicklungen (61 und 66) klein gegen den radialen Innendurchmesser dᵢ sind und zwischen 4% und 6% bzw. zwischen 5% und 7% desselben betragen.

6. Magnetsystem nach Anspruch 4 und Anspruch 5,
dadurch gekennzeichnet, daß die zwischen den axial äußeren Stirnseiten (73) der axial äußeren Wicklungen (61 und 66) der radial inneren Feldspule (11) gemessene Länge L_{;} derselben zwischen 85% und 95% der entsprechend gemessenen Länge Lₐ der radial äußeren Feldspule (12) beträgt, daß der radiale Innendurchmesser Dᵢ der radial äußeren Feldspule (12) zwischen 90% und 95% der axialen Länge Lₐ der radial äußeren Feldspule (12) entspricht, und daß das Verhältnis D_{;}/d_{;} des radialen Innendurchmessers Dᵢ der radial äußeren Feldspule (12) zu dem radialen Innendurchmesser dᵢ der radial inneren Feldspule (11) einen Wert um 1,4 hat, und daß die beiden Feldspulen ( 11 und 12 ) im Betrieb des Magnetsystems (10) mit derselben Stromdichte beaufschlagt sind.

7. Magnetsystem nach einem der vorhergehenden Ansprüche, dadurch gekennzeichnet, daß die beiden Feldspulen ( 11 und 12 ) in Reihe geschaltet sind.

8. Magnetsystem nach einem der vorhergehenden Ansprüche, dadurch gekennzeichnet, daß als Betriebsmodus-Wahlschalteinrichtung ein supraleitendes Schalt-Netzwerk ( 22 ) vorgesehen ist.

9. Magnetsystem nach Anspruch 8, dadurch gekennzeichnet, daß das supraleitende Schalt- Netzwerk (22) 4 supraleitende elektrische Strömungspfade ( 29,31,38 und 39 ) umfaßt, die durch Beheizung in den resistiven, einen Suprastrom sperrenden Zustand steuerbar sind, wobei durch diese Strömungspfade ( 29,31,38 und 39 ) jeder der beiden Anschlüsse ( 32 und 33 ) der radial äußeren Feldspule (12) mit jedem der beiden Anschlüsse ( 23 und 28 ) der radial inneren Feldspule (11) verbindbar bzw. gegen diese absperrbar ist bzw. sind.

10. Magnetsystem nach Anspruch 9, dadurch gekennzeichnet, daß im Ladebetrieb jeweils nur einer der beiden supraleitenden Strompfade ( 29 bzw. 31 ) freigegeben ist, über den die Hintereinanderschaltung der beiden Feldspulen (11 und 12) erfolgt, und , sobald die Sollstromstärke erreicht ist, auch derjenige Strompfad ( 39 bzw. 38 ) in den supraleitenden Zustand gebracht wird, der das Ladegerät überbrückt und den Stromkreis der hintereinander geschalteten Feldspulen ( 11 und 12 ) schließt, und danach die beiden anderen Strompfade ebenfalls auf supraleitenden Durchgang geschaltet werden.

11. Magnetsystem nach einem der vorhergehenden Ansprüche, dadurch gekennzeichnet, daß ein Shim-System vorgesehen ist, durch das Feldgradienten erzeugbar sind, durch die in den alternativen Betriebsarten die hieraus resultierenden Inhomogenitäten des Magnetfeldes im Untersuchungsraum mindestens teilweise ausgleichbar sind.

12. Magnetsystem nach einem der vorhergehenden Ansprüche, dadurch gekennzeichnet, daß eine passive Eisenabschirmung (87) vorgesehen ist.

13. Magnetsystem nach Anspruch 12,
dadurch gekennzeichnet, daß die Eisen-Abschirmung (87) Stirnplatten (88 und 89) und diese axial miteinander verbindende balkenförmige Elemente (91 und 92) umfaßt, welche den Kryostaten (13) des Magnetsystems (10) unmittelbar umgeben.

14. Magnetsystem nach Anspruch 12 oder 13, dadurch gekennzeichnet, daß die Eisen-Abschirmung (87) durch
(i) austauschbare Gestaltung insgesamt,
(ii) Hinzufügen von Elementen und/oder
(iii) Entfernen von Elementen und/oder
(iv) Austauschen von Elementen und/oder
(v) Verschieben von Elementen
auf die verschiedenen Betriebsarten des Magnetsystems (10) umrüstbar ist.

15. Magnetsystem nach einem der vorhergehenden Ansprüche, gekennzeichnet durch seine Ausbildung als mobiles System, das als eine auf ein Transportfahrzeug aufsetzbare kompakte Einheit oder als ein in ein Transportfahrzeug integriertes Gerät ausgebildet ist.

16. Magnetsystem nach Anspruch 15,
dadurch gekennzeichnet, daß ein Transportbehälter des Magnetsystems und/oder ein Teil des Transportfahrzeuges als Funktionselement der Eisenabschirmung (87) ausgebildet ist.

## Claims

1. Magnet system (10) comprising superconducting field coils to generate a magnetic field suitable for NMR experiments, which has a high field strength in the experimental volume and sufficient homogeneity for NMR experiments, tomographic, and/or spectroscopic investigations, with two coil systems of different mean diameter arranged coaxially with respect to the longitudinal axis (14) of the system defined by the direction of the field in the homogeneous region, which are rotationally symmetric and are arranged symmetrically with respect to the transverse median plane of the system which is perpendicular to the longitudinal axis, and can carry exciting currents which result in overlapping magnetic fields that compensate, at least approximately, for the dipole fields of the two coil systems, characterized in that an operating mode selector switch device (22) is provided, by means of which the magnet system (10) can also be switched, as an alternative to the operating mode which substantially provides dipole-field compensation exterior to the magnet system (10), to at least that operating mode in which the magnetic fields generated by the two coil systems (11 and 12) at the center thereof are aligned in the same direction.

2. Magnet system according to claim 1, characterized in that the ratio Bo/Boa between the magnitudes of the axial field strengths Bₒ; and Bₒₐ generated by the radially inner field coil (11) and the radially outer field coil (12) is, in the center (19) of the magnet system (10), equal to approximately 3.

3. Magnet system according to claim 1 or claim 2, characterized in that the radially inner field coil (11) is at least an 8th-order coil, preferably a 12th-order coil, and the radially outer field coil is at least a 6th-order, preferably an 8th-order coil.

4. Magnet system according to claim 3, characterized in that the radially outer field coil (12) comprises at least four subcoils (74 to 77) of the same winding density - arranged at axial distances from one another and through which, when viewed in the direction of the central axis (14) of the magnet system (10), exciting current flows in the same direction - which preferably have the same inside radial diameter Dᵢ and the same outside radial diameter Dₐ, with the number of turns in the axially outer coils (74 and 77) being between 2.5 and 3.5 times greater than the number in the axially inner coils (75 and 76), the radial thickness (Dₐ - Dᵢ) of the subcoils (74 to 77) being small compared to the mean radial diameter (Dₐ - Dᵢ)/2, and between 2% and 4% thereof.

5. Magnet system according to claim 3 or claim 4, characterized in that the radially inner field coil (11) comprises at least six subcoils (61 to 66) of the same winding density - arranged at axial distances from one another and through which, when viewed in the direction of the central axis (14) of the magnet system (10), exciting current flows in the same direction - which preferably have the same inside radial diameter dᵢ, with the number of turns in the middle coils (62 and 65) located between the respective axially inner coils (63 and 64) and the axially outer coils (61 and 66) being between 1.3 and 1.6 times greater than the number in the axially inner coils (63 and 64), and the number of turns in the axially outer coils (61 and 62) being between 3.5 and 4 times greater than the number in the axially inner coils (63 and 64), and furthermore with the radial thicknesses (dₐ₂ - dᵢ) of the axially inner and middle coils (63 and 64, and 62 and 65) and the radial thicknesses (dₐᵢ - dᵢ) of the axially outer coils (61 and 66) being small compared to the inside radial diameter dᵢ, and between 4% and 6%, and 5% and 7%, respectively, thereof.

6. Magnet system according to claim 4 and claim 5, characterized in that the length L_{;} of the radially inner field coil (11) measured between the axially outer ends (73) of the axially outer coils (61 and 66) thereof is between 85% and 95% of the correspondingly measured length Lₐ of the radially outer field coil (12), the inside radial diameter Dᵢ of the radially outer field coil (12) corresponding to between 90% and 95% of the axial length Lₐ of the radially outer field coil (12), and the ratio D_{;}/d_{;} between the inside radial diameter Dᵢ of the radially outer field coil (12) and the inside radial diameter dᵢ of the radially inner field coil (11) is equal to approximately 1.4, and the two field coils (11 and 12) carry the same current density when the magnet system (10) is in operation.

7. Magnet system according to any of the preceding claims, characterized in that the two field coils (11 and 12) are connected in series.

8. Magnet system according to any of the preceding claims, characterized in that a superconducting switching network (22) is provided as an operating mode selector switch device.

9. Magnet system according to claim 8, characterized in that the superconducting switching network (22) comprises 4 superconducting electrical current paths (29, 31, 38, and 39), which can be switched, by heating, into a resistive state which blocks superconductive current, such that by means of these current paths (29, 31, 38, and 39), each of the two connections (32 and 33) of the radially outer field coil (12) can be connected to or blocked off from each of the two connections (23 and 28) of the radially inner field coil (11).

10. Magnet system according to claim 9, charaterized in that during energization, only one of the two superconducting current paths (29 or 31), by means of which the two field coils (11 and 12) are connected in series with one another, is open in each case, and, as soon as the reference current density is reached, the current path (39 or 38) which bypasses the energizing unit and closes the circuit to the field coils (11 and 12), connected in series, is switched into the superconducting state, and thereafter the other two current paths are also switched to superconducting transmission.

11. Magnet system according to any of the preceding claims, characterized in that a shim system is provided, capable of generating field gradients by means of which, in the alternative operating modes, the resulting inhomogeneities of the magnetic field in the experimental volume can be at least partially compensated for.

12. Magnet system according to any of the preceding claims, characterized in that a passive iron shield (87) is provided.

13. Magnet system according to claim 12, characterized in that iron shield (87) comprises end plates (88 and 89) and beam-shaped elements (91 and 92) which axially connect the plates to one another, which directly surround the cryostat (13) of the magnet system (10).

14. Magnet system according to claim 12 or 13, characterized in that the iron shield (87) can be adapted to the various operating modes of the magnet system (10) by means of:
(i) Overall replaceable configuration;
(ii) Addition of elements; and/or
(iii) Removal of elements; and/or
(iv) Replacement of elements; and/or
(v) Displacement of elements.

15. Magnet system according to any of the preceding claims, characterized by its configuration as a mobile system, which is configured as a compact unit that can be placed on a transport vehicle or as a unit that is integrated into a transport vehicle.

16. Magnet system according to claim 15, characterized in that a transport container for the magnet system and/or a part of the transport vehicle is configured as a functional element of the iron shield (87).

## Revendications

1. Système magnétique (10) avec des bobines inductrices supraconductrices pour l'engendrement d'un champ magnétique approprié pour des examens RMN, qui a une intensité de champ élevée dans un volume d'examen et une homogénéité suffisante pour des expérimentations RMN, des examens tomographi- ques et/ou spectroscopiques, avec deux systèmes de bobine (11, 12) agencés coaxialement par rapport à l'axe longitudinal (14) du système caractérisé par la direction de champ dans la zone d'homogénéité, de diamètre radial médian différent, lesquels sont constitués symétriques en rotation et symétriques par rapport au plan médian transversal (16) du système normal à l'axe longitudinal (14) et sont sollicita- bles avec des courants d'excitation, à partir desquels résultent des champs magnétiques se superposant, qui imposent au moins approximativement, dans l'espace extérieur du système magnétique, la compensation des champs dipolaires aux deux systèmes de bobine,
caractérisé en ce qu'un agencement de commutation de sélection de mode d'exploitation (22) est prévu, au moyen duquel le système magnétique (10), alternativement, est commutable au type d'exploitation imposant la - considérable - compensation de champ dans l'espace extérieur du système magnétique (10), aussi au moins à ce type d'exploitation, dans lequel les champs magnétiques, engendrés par les deux systèmes de bobine (11 et 12) dans le centre de ceux-ci, sont orientés de façon égale.

2. Système magnétique selon la revendication 1, caractérisé en ce que le rapport Bo1/Boa des valeurs des intensités de champ Boi et Boa des champs axiaux engendrés par la bobine inductrice intérieure radiale (11) et la bobine inductrice extérieure radiale (12), dans le centre (19) du système magnétique (10), a de façon approximative la valeur 3.

3. Système magnétique selon la revendication 1 ou la revendication 2, caractérisé en ce que la bobine inductrice intérieure radiale (11) est une bobine d'au moins 8ème ordre, de façon préférée une bobine de 12ème ordre, et la bobine inductrice extérieure radiale (12) est une bobine d'au moins 6ème ordre, de façon préférée 8ème ordre.

4. Système magnétique selon la revendication 3, caractérisé en ce que la bobine inductrice extérieure radiale (12) comprend au moins quatre bobinages partiels (74 à 77), vu en direction de l'axe central (14) du système magnétique (10), agencés dans des espacements axiaux les uns des autres, parcourus par un courant d excitation de même sens, de même densité d'enroulement, lesquels, de façon préférée, ont le même diamètre intérieur radial Di et le même diamètre extérieur radial Da, où, les nombres de spires des bobinages extérieurs axiaux (74 et 77) sont entre 2,5 et 3,5 fois plus grands que ceux des bobinages intérieurs axiaux (75 et 76), et l'épaisseur radiale (Da - Di) des bobinages partiels (74 à 77) est petite par rapport au diamètre radial moyen (Da + Di)/2 et atteint entre 2 % et 4 % de celui-ci.

5. Système magnétique selon la revendication 3 ou la revendication 4, caractérisé en ce que la bobine inductrice intérieure radiale (11) comprend au moins six bobinages partiels (61 à 66), vu en direction de l'axe central (14) du système magnétique (10), agencés dans des espacements axiaux les uns des autres, de même densité d'enroulement, lesquels, de façon préférée, ont le même diamètre intérieur radial di, où, le nombre de spires des bobinages (62 ou bien 65) médians, agencés entre, chaque fois, les bobinages intérieurs axiaux (63 ou bien 64) et les bobinages extérieurs axiaux (61 ou bien 66), est entre 1,3 et 1,6 fois plus grand que celui dès bobinages intérieurs axiaux (63 ou bien 64), et les nombres de spires des bobinages extérieurs axiaux (61 et 62) sont entre 3,5 et 4 fois plus grands que ceux des bobinages intérieurs axiaux (63 ou bien 64), où, de plus, les épaisseurs radiales (da2 - di) des bobinages intérieurs axiaux et des bobinages médians (63 et 64 ou bien 62 et 65) et les épaisseurs radiales (dai - di) des bobinages extérieurs axiaux (61 et 66) sont petites par rapport au diamètre intérieur radial di et atteignent entre 4 % et 6 % ou bien entre 5 % et 7 % de celui-ci.

6. Système magnétique selon la revendication 4 et la revendication 5, caractérisé en ce que la longueur Li de celui-ci, mesurée entre les côtés frontaux extérieurs axiaux (73) des bobinages extérieurs axiaux (61 et 66) de la bobine inductrice intérieure radiale (11), atteint entre 85 % et 95 % de la longueur La de la bobine inductrice extérieure radiale (12) mesurée de façon correspondante, que le diamètre intérieur radial Di de la bobine inductrice extérieure radiale (12) correspond à entre 90 % et 95 % de la longueur La axiale de la bobine inductrice extérieure radiale (12), et que le rapport Di/di du diamètre intérieur radial Di de la bobine inductrice extérieure radiale (12) au diamètre intérieur radial di de la bobine inductrice intérieure radiale (11) a une valeur de 1,4, et que les deux bobines inductrices (11 et 12), dans l'exploitation du système magnétique (10), sont sollicitées avec la même densité de courant.

7. Système magnétique selon une des précédentes revendications, caractérisé en ce que les deux bobines inductrices (11 et 12) sont mises en circuit en série.

8. Système magnétique selon une des revendications précédentes, caractérisé en ce que comme agencement de commutation de sélection de mode d'exploitation, un bloc d'alimentation de circuit supraconduisant (22) est prévu.

9. Système magnétique selon la revendication 8, caractérisé en ce que le bloc d'alimentation de circuit supraconduisant (22) comprend quatre trajets d'écoulement électriques supracondui- sants (29, 31, 38 et 39), qui sont commanda- bles par échauffement dans l'état résistif, bloquant un courant de supraconductivité, ou, grâce à ces chemins d'écoulement (29, 31, 38 et 39), chacun des deux raccordements (32 et 33) de la bobine inductrice extérieure radiale (12) est, ou bien sont, reliable(s) avec chacun des deux raccordements (23 et 28) de la bobine inductrice intérieure radiale (11), ou bien est, ou bien sont, isolable(s) par rapport à ceux-ci.

10. Système magnétique selon la revendication 9, caractérisé en ce que dans l'exploitation de charge, chaque fois, seul un deux chemins de courant supraconduisant (29 ou bien 31) est rendu libre, par l'intermédiaire duquel, la mise en circuit l'une derrière l'autre des deux bobines inductrices (11 et 12) a lieu, et, aussitôt que l'intensité de courant à atteindre est atteinte, aussi est amené dans l'état supraconduisant ce chemin de courant (39 ou bien 38), qui ponte l'appareil de charge et ferme le circuit de courant des bobines inductrices (11 et 12) mises en circuit l'une derrière l'autre, et après cela, les deux autres chemins de courant sont également mis en état de passage supraconduisant.

11. Système magnétique selon une des revendications précédentes, caractérisé en ce qu'un système de calage est prévu, à travers lequel des gradients de champ sont engendrables, grâce auxquels, dans les types d'exploitation alternatifs, les inhomogénéités du champ magnétique résultant de ceci, dans l'espace d'examen, sont au moins partiellement compensables.

12. Système magnétique selon une des précédentes revendications, caractérisé en ce qu'un blindage de fer passif (87) est prévu.

13. Système magnétique selon la revendication 12, caractérisé en ce que le blindage de fer (87) comprend des plaques frontales (88 et 89) et des éléments en forme de barres (91 et 92) reliant celles-ci l'une avec l'autre axialement, lesquels entourent directement le cryostat (13) du système magnétique (10).

14. Système magnétique selon la revendication 12 ou la revendication 13, caractérisé en ce que le blindage de fer (87) est adaptable aux différents types d'exploitation du système magnétique (10) par
(i) configuration totale échangeable, (ii) adjonction d'éléments et/ou
(iii) enlèvement d'éléments et/ou
(iv) échange d'éléments et/ou
(v) décalage d'éléments.

15. Système magnétique selon une des précédentes revendications, caractérisé par sa constitution comme système mobile, qui est constitué comme une unité compacte installable sur un véhicule de transport, ou comme un appareil intégré dans un véhicule de transport.

16. Système magnétique selon la revendication 15, caractérisé en ce qu'un récipient de transport du système magnétique et/ou une partie du véhicule de transport sont constitués comme élément fonctionnel du blindage de fer (87).
